# EUROPÄISCHE PATENTSCHRIFT

(11) **EP 2 665 350 B1**
(45) Veröffentlichungstag und Bekanntmachung des Hinweises auf die Patenterteilung: **04.10.2023**
(21) Anmeldenummer: 13002511.7
(22) Anmeldetag: 14.05.2013
(51) Int. Cl.: H05K 7/20

(54) **Gebläseeinheit zur Kühlung von Aggregaten, wie elektrische/elektronische Baugruppen, Geräte und dergleichen**
Fan unit for cooling of apparatus, such as electrical/electronic assemblies, equipment and the like
Unité de ventilateur pour le refroidissement de modules, tels que des modules électriques/électroniques, des appareils et analogues

(30) Priorität: 14.05.2012 DE 102012010116
(43) Veröffentlichungstag der Anmeldung: 20.11.2013
(73) Patentinhaber: ZIEHL-ABEGG SE, 74653 Künzelsau (DE)
(72) Erfinder: Schulze Dieckhoff, Bernhard, Dr., 28857 Syke (DE); Geiger, Michael, 74177 Bad Friedrichshall (DE); Maurer, Tobias, 74653 Künzelsau (DE)
(74) Vertreter: Kohl, Karl-Heinz

(56) Entgegenhaltungen:
- EP-A1- 2 242 347
- DE-A1- 10 164 626
- DE-A1-102008 026 692
- DE-B- 1 131 355
- DE-U1-202011 103 765
- JP-A- 2011 134 803
- US-A1- 2006 054 380

## Beschreibung

Die Erfindung betrifft eine Gebläseeinheit zur Kühlung von Aggregaten, wie elektrische/elektronische Baugruppen, Geräte und dergleichen, nach dem Oberbegriff des Anspruches 1.

Eine solche Gebläseeinheit ist aus EP 2 242 347 A1 bekannt.

Es ist bekannt, mit Gebläseeinheiten Wärmetauscher zu kühlen. Hierfür werden überwiegend Axialventilatoren eingesetzt, da zur Kühlung der Wärmetauscher meist ein hoher Volumenstrom bei vergleichsweise geringem Druck benötigt wird. Solche Axialventilatoren sind jedoch im Einsatz der Gebläseeinheit im Hinblick auf die akustischen Eigenschaften nicht optimal.

Es sind auch Gebläseeinheiten bekannt, die mehrere nebeneinander angeordnete Ventilatoren aufweisen (US 5 890 959, DE 1 131 355, US 6 094 346, US 5 880 932), die in einem Gehäuse angeordnet sind. Die Drehachsen ihrer Lüfterräder liegen parallel zueinander und im Wesentlichen parallel zur Achse der Durchströmöffnung. Solche Gebläseeinheiten benötigen jedoch einen erheblichen Bauraum. Zur Trennung der nebeneinander liegenden Ventilatoren sind Trennbleche und dergleichen erforderlich.

Es ist eine Gebläseeinheit bekannt (DE 20 2011 103 765 U1), die in einem gehäuseartigen Tragkörper winklig zueinander liegende Radialventilatoren aufweist. Sie saugen jeweils Luft von außen über Einströmöffnungen an. Innerhalb des Tragkörpers vermischen sich die Luftströme, bevor sie über eine Durchströmöffnung nach außen gelangen.

Vor der Durchströmöffnung befindet sich das zu kühlende Aggregat, das durch den aus der Durchströmöffnung austretenden Kühlstrom gekühlt wird. Es ist weiter ein Klimaraum bekannt (JP 2011/134803 A), in dem übereinander mehrere Gebläse angeordnet sind, die jeweils Umgebungsluft in den Klimaraum saugen. Von hier aus wird die Luft durch schräg zueinander liegende Gebläse im Deckenbereich nach außen gefördert.

Es ist weiter eine Wärmetauschereinheit bekannt (EP 2 242 347 A1), in deren Gehäuse zwei rechtwinklig zueinander liegende Ventilatoren angeordnet sind, die jeweils über eine Eintrittsöffnung Außenluft ansaugen und über jeweils eine Durchströmöffnung wieder nach außen abgeben.

Es ist eine Gebläseeinheit bekannt (DE 10 2008 026 692 A1), in deren Gehäuse nebeneinander Ventilatoren angeordnet sind, die auf einer gemeinsamen Welle angeordnet sind. Die Achsen der Radialventilatoren liegen somit fluchtend zueinander.

Es ist schließlich eine Gebläseeinheit bekannt (DE 1 131 355 B), die mit einem Gehäuse versehen ist, in dem ein einziges Gebläse angeordnet ist.

Es ist weiter ein universelles Lüfteraufnahmesystem bekannt (DE 101 64 626 A1), welches einen schnellen Wechsel von Lüftern ermöglicht, und den Luftumsatz und Sicherheit durch die Mehrfach-Anordnung von Ventilatoren erhöht.

Der Erfindung liegt die Aufgabe zugrunde, die gattungsgemäße Gebläseeinheit so auszubilden, dass sie bei kompakter Ausbildung und gutem Wirkungsgrad optimale akustische Eigenschaften aufweist.

Diese Aufgabe wird bei der gattungsgemäßen Gebläseeinheit erfindungsgemäß mit den kennzeichnenden Merkmalen des Anspruches 1 gelöst.

Bei der erfindungsgemäßen Gebläseeinheit werden als Ventilatoren Radialventilatoren eingesetzt. Sie werden so angeordnet, dass die Drehachsen ihrer Lüfterräder unter einem Winkel zur Achse wenigstens einer Durchströmöffnung des Tragkörpers liegen. Über die Durchströmöffnung ist der Innenraum des Tragkörpers mit dem Umgebungsraum der Gebläseeinheit strömungstechnisch verbunden. Aufgrund der winkligen Lage der Drehachsen sowie der Achse der Durchströmöffnung zueinander kann die Gebläseeinheit sehr kompakt gebaut werden, so dass sie nur wenig Einbauraum benötigt. Würde nur ein einzelner Radialventilator zur Kühlung herangezogen werden, dann würde der Betriebspunkt sehr ungünstig liegen. Bei der erfindungsgemäßen Gebläseeinheit wird der Volumenstrom jedoch auf wenigstens zwei Radialventilatoren aufgeteilt. Durch Auswahl der passenden Ventilatorbaugröße kann dadurch der Betriebspunkt in den optimalen Arbeitsbereich des einzelnen Radialventilators verschoben werden. Aufgrund der erfindungsgemäßen Ausbildung ergibt sich ein hoher Wirkungsgrad der Gebläseeinheit, der wesentlich besser ist als bei Verwendung der üblichen Axialventilatoren. Auch wird mit der erfindungsgemäßen Gebläseeinheit eine im Vergleich zu Axialventilatoren deutliche Verbesserung der akustischen Eigenschaften erzielt. Die winklige Anordnung der Drehachsen der Lüfterräder der Radialventilatoren zur Achse der Durchströmöffnung ermöglicht darüber hinaus eine hohe Leistungsdichte bei vorgegebenem Bauraum.

Die Radialventilatoren sind an winklig zueinander liegenden und/oder an einander gegenüberliegenden Seitenwänden des Tragkörpers angeordnet. Der Tragkörper ist ein Gehäuse, an dessen Seitenwänden die Radialventilatoren vorgesehen sind. Hierbei können die Seitenwände rechtwinklig aneinander anschließen. Je nach Einsatzfall und/oder Einbauverhältnissen können die Seitenwände des Tragkörpers auch abweichend von 90° zueinander liegen.

Die Durchströmöffnung für den von den Radialventilatoren erzeugten Luftstrom liegt einer die Seitenwände verbindenden Rückwand des Tragkörpers gegenüber. Durch die Rückwand ist gewährleistet, dass die von den Radialventilatoren erzeugten Luftströme vollständig durch die Durchströmöffnung strömen. Dadurch ist eine hervorragende Kühlung des Aggregates gewährleistet.

Die Radialventilatoren sind so am Tragkörper montiert, dass zumindest die Lüfterräder außerhalb des Tragkörpers liegen. In diesem Falle saugen die Radialventilatoren die Kühlluft durch die Durchströmöffnung in den Innenraum des Tragkörpers an und geben sie in den Umgebungsraum ab. In diesem Falle wird das vor der Durchströmöffnung befindliche Aggregat, bezogen auf den Tragkörper, von außen nach innen durchströmt, so dass die Gebläseeinheit für eine saugende Anwendung eingesetzt werden kann.

Die Kühlluft wird durch die Durchstromöffnung angesaugt und durchströmt das im Bereich der Seitenwand angeordnete zu kühlende Aggregat. Die Kühlluft gelangt in den Tragkörper und wird über die Radialventilatoren radial wieder nach außen geblasen.

Die Durchströmöffnung kann dadurch gebildet sein, dass der Tragkörper an der der Rückwand gegenüberliegenden Seite vollständig offen ist. Das zu kühlende Aggregat kann darum eine verhältnismäßig große Querschnittsfläche aufweisen.

Es ist aber auch möglich, dass der Tragkörper an der der Rückwand gegenüberliegenden Seite mit einer Seitenwand versehen ist, in der sich wenigstens eine Durchströmöffnung befindet. Eine solche Ausbildung bietet sich dann an, wenn das zu kühlende Aggregat nur eine geringe zu beaufschlagende Fläche aufweist. Durch die die Durchströmöffnung aufweisende Seitenwand ist dann gewährleistet, dass der von den Radialventilatoren erzeugte Luftstrom vollständig an das zu kühlende Aggregat gelangt.

Die einander gegenüberliegend angeordneten Radialventilatoren können vorteilhaft so vorgesehen sein, dass die Drehachsen ihrer Lüfterräder in einer gemeinsamen Ebene liegen. Hierbei können die Drehachsen der Radialventilatoren fluchtend, aber auch winklig zueinander liegen.

Die einander gegenüberliegenden Radialventilatoren können aber auch so angeordnet sein, dass die Drehachsen ihrer Lüfterräder in unterschiedlichen Ebenen liegen.

Die unterschiedliche Lage der Radialventilatoren am Tragkörper ermöglicht somit eine optimale Anpassung an die jeweils geforderten Einsatz- und/oder Einbauverhältnisse.

Das Gehäuse kann beispielsweise quader- oder würfelförmig ausgebildet sein. Dann können beispielsweise an vier Seitenwänden die Radialventilatoren so angeordnet sein, dass jeweils zwei Radialventilatoren einander gegenüberliegen. Auf diese Weise ergibt sich bei sehr kompakter Ausbildung eine hohe Leistungsdichte.

Die Radialventilatoren können in der zugehörigen Seitenwand mittig angeordnet sein. Es ist aber auch möglich, die Radialventilatoren in der Seitenwand außermittig vorzusehen.

Weitere Merkmale der Erfindung ergeben sich aus den weiteren Ansprüchen, der Beschreibung und den Zeichnungen.

Die Erfindung wird anhand einer in den Zeichnungen dargestellten Ausführungsform näher erläutert. Es zeigen
- Fig. 1: in perspektivischer Darstellung eine nicht zur Erfindung gehörende Gebläseeinheit,
- Fig. 2: einen Schnitt durch die Gebläseeinheit gemäß Fig. 1,
- Fig. 3: einen Schnitt längs der Linie III-III in Fig. 2,
- Fig. 4: eine Seitenansicht der Gebläseeinheit,
- Fig. 5: in perspektivischer Darstellung eine erfindungsgemäße Gebläseeinheit,
- Fig. 6: einen Schnitt durch die Gebläseeinheit gemäß Fig. 5,
- Fig. 7: einen Schnitt längs der Linie VII-VII in Fig. 5,
- Fig. 8: eine Seitenansicht der Gebläseeinheit gemäß Fig. 5,
- Fig. 9: verschiedene Kennlinien der erfindungsgemäßen Gebläseeinheit.

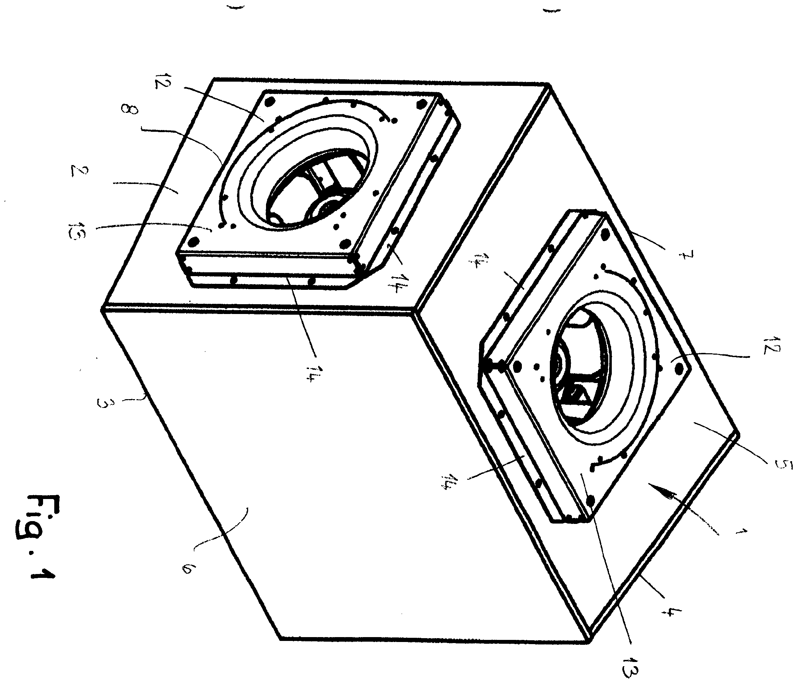

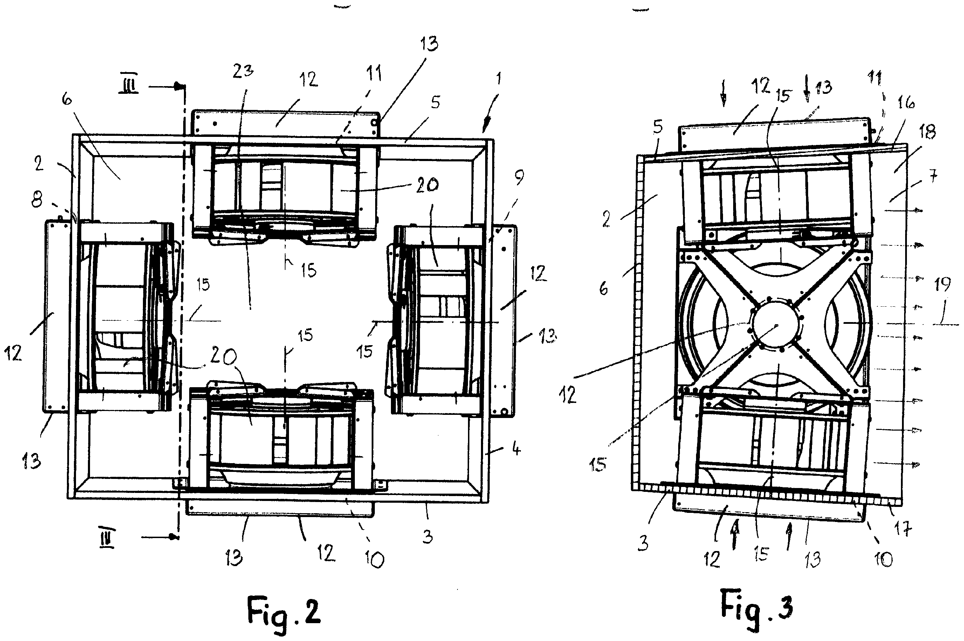

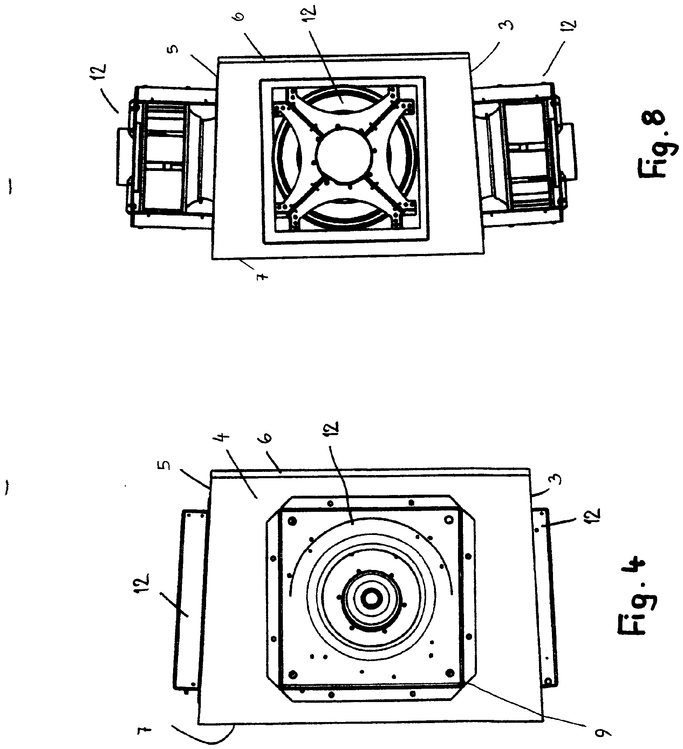

Die Gebläseeinheit dient dazu, elektrische/elektronische Baugruppen, Geräte oder dergleichen bei geringer Baugröße und nur minimaler Geräuschentwicklung optimal zu kühlen. Die Fig. 1 bis 4 zeigen eine nicht erfindungsgemäße Gebläseeinheit mit einem Tragkörper 1, der beispielhaft quaderförmig oder würfelförmig ausgebildet ist. Der Tragkörper 1 hat winklig aneinander anschließende Seitenwände 2 bis 5, die durch eine Rückwand 6 miteinander verbunden sind. Die der Rückwand 6 gegenüberliegende Seite 7 des Tragkörpers 1 kann offen sein oder eine Wand aufweisen, in der sich wenigstens eine Durchströmöffnung befindet. Im Folgenden wird diese Seite des Tragkörpers 1 als Seitenwand 7 bezeichnet. Die Seitenwände 2 bis 7 können rechtwinklig zueinander liegen. Im Ausführungsbeispiel verlaufen die Seitenwände 3 und 5 von der Rückwand 6 aus in Richtung auf die gegenüberliegende Seitenwand 7 divergierend (Fig. 3 und 4). Auch die Seitenwände 2 und 4 verlaufen von der Rückwand 6 aus in Richtung auf die Seitenwand 7 divergierend (Fig. 2). Die Wände 2 bis 7 haben jeweils rechteckigen Umriss.

Der beschriebene Verlauf und die beschriebene Umrissform der Wände 2 bis 7 des Tragkörpers 1 sind nur als Beispiel zu verstehen und nicht zwingende Voraussetzung für die Gestaltung des Tragkörpers 1. Er kann je nach Einbaugegebenheiten und/oder je nach gewünschtem Anforderungsprofil auch eine andere Gestaltung haben. Er muss auch keine eckige Querschnittsform haben, sondern kann auch abgerundete Querschnittsform aufweisen.

Die Seitenwände 2 bis 5 haben jeweils eine Aufnahmeöffnung 8 bis 11, in die jeweils ein Radialventilator 12 eingesetzt ist. Die Aufnahme- bzw. Einbauöffnungen 8 bis 11 sind vorteilhaft mittig in den Seitenwänden 2 bis 5 vorgesehen. Die Radialventilatoren 12 sind jeweils mit Hilfe eines Einbaurahmens 13 am Tragkörper 1 befestigt. Die Einbaurahmen 13 haben Flansche 14, die auf der Außenseite der entsprechenden Wände des Tragkörpers 1 aufliegend befestigt sind. Die Radialventilatoren ragen größtenteils in den Tragkörper 1 und stehen nur wenig über die Wände 2 bis 5 des Tragkörpers 1 vor. Die Radialventilatoren 12 können auch so eingebaut sein, dass sie nicht nach außen über den Tragkörper 1 vorstehen.

Die Radialventilatoren 12 sind in bekannter Weise ausgebildet und werden darum auch nicht näher beschrieben. Da die Seitenwände 2 bis 5 im Beispielsfalle geneigt verlaufen, liegen die Drehachsen 15 der Lüfterräder der Radialventilatoren 12 winklig zueinander. Dabei schließen die Drehachsen 15 einander gegenüberliegender Ventilatoren 12 jeweils einen stumpfen Winkel miteinander ein (Fig. 3). Sind die die Radialventilatoren 12 tragenden Wände 2 bis 5 parallel bzw. rechtwinklig zueinander angeordnet, dann liegen die Drehachsen 15 einander gegenüberliegender Radialventilatoren 12 fluchtend zueinander.

Wie sich aus Fig. 2 ergibt, ragen die Radialventilatoren 12 so weit in den Tragkörper 1, dass sie nur geringen Abstand voneinander haben. Die Radialventilatoren 12 sind so innerhalb des Tragkörpers 1 angeordnet, dass sie Abstand von der der Austrittsöffnung gegenüberliegenden Rückwand 6 haben.

Die Lüfterräder der Radialventilatoren 12 befinden sich innerhalb des Tragkörpers 1 und saugen im Betrieb Außenluft an (Strömungspfeile in Fig. 3), die in den Innenraum 23 des Tragkörpers 1 gelangt. Ein Teil der angesaugten Kühlluft gelangt von jedem Radialventilator 12 unmittelbar zur Austrittsöffnung 7. Da die Radialventilatoren 12 über den inneren Umfang des Tragkörpers 1 gleichmäßig verteilt angeordnet sind, wird die Kühlluft gleichmäßig über den Querschnitt der Austrittsöffnung 7 ausgeblasen. Ein Teil der von den Radialventilatoren 12 angesaugten Außenluft gelangt auch in Richtung auf die Rückwand 6, an der dieser Teil der Kühlluft in Richtung auf die Austrittsöffnung 7 umgelenkt wird.

Die Gebläseeinheit ist vorteilhaft so ausgebildet, dass in die Austrittsöffnung 7 das zu kühlende Aggregat, beispielsweise ein Wärmetauscher, eingesetzt werden kann. Wie sich aus Fig. 3 ergibt, stehen die Seitenwände 2 bis 5 über die Radialventilatoren 12 vor, so dass die überstehenden Ränder 16 bis 18 beispielsweise als Aufnahmerahmen für das zu kühlende Aggregat herangezogen werden können. Die durch die Austrittsöffnung 7 strömende Kühlluft durchströmt das zu kühlende Aggregat, das dadurch optimal auf eine gewünschte Temperatur gekühlt bzw. auf einer gewünschten Temperatur gehalten werden kann.

Die Radialventilatoren 12 sind so angeordnet, dass ihre Drehachsen 15 winklig zur Achse 19 der Ausströmöffnung 7 liegen.

Die beschriebene Anordnung der Radialventilatoren 12 im Tragkörper 1 führt zu einer sehr kompakten Bauform der Gebläseeinheit. Um die Kühlluft zur Ausströmöffnung 7 zu lenken, sind innerhalb des Tragkörpers 1 keine Strömungsleitelemente erforderlich. Der Tragkörper 1 kann dadurch sehr einfach aufgebaut, beispielsweise durch einen Blechkasten gebildet sein.

Wie aus Fig. 2 hervorgeht, sind die einander gegenüberliegenden Radialventilatoren 12 so angeordnet, dass ihre jeweiligen Drehachsen 15 jeweils in einer gemeinsamen Ebene liegen. Abweichend von einer solchen Ausführung können die Radialventilatoren auch so vorgesehen sein, dass einander gegenüberliegende Radialventilatoren 12 relativ zueinander versetzt angeordnet sind, so dass ihre Drehachsen nicht in einer gemeinsamen Ebene liegen. Hierbei können alle einander gegenüberliegenden Radialventilatoren 12 gegeneinander versetzt angeordnet sein, oder es können auch nur zwei einander gegenüberliegende Radialventilatoren 12 den Versatz aufweisen, während die beiden anderen einander gegenüberliegenden Radialventilatoren 12 so angeordnet sind, dass ihre Drehachsen 15 in einer gemeinsamen Ebene liegen.

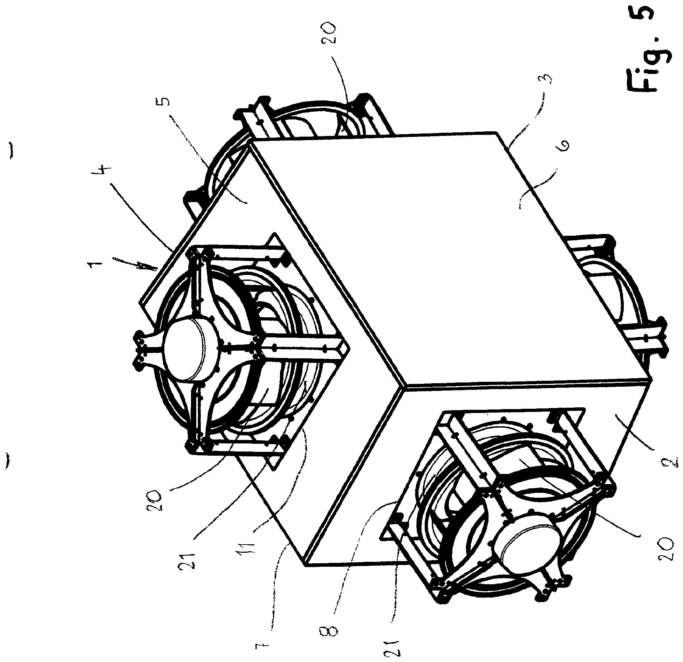

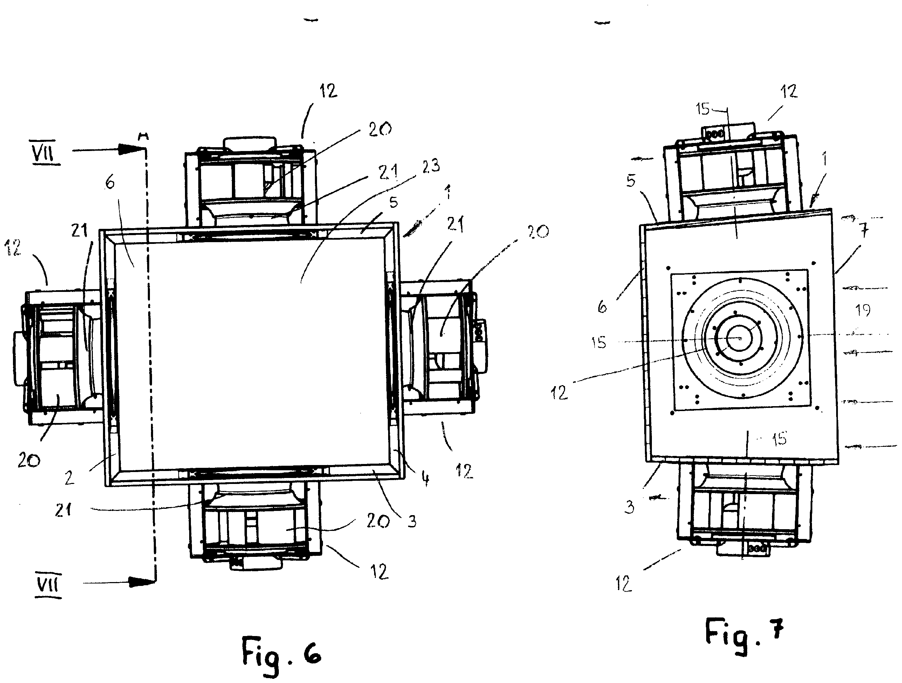

Die erfindungsgemäße Gebläseeinheit gemäß den Fig. 5 bis 8 ist grundsätzlich gleich ausgebildet wie die nicht erfindungsgemäße, zuvor beschriebene Gebläseeinheit. Der Unterschied liegt darin, dass die Radialventilatoren so weit außerhalb des Tragkörpers 1 liegen, dass zumindest die Lüfterräder 20 außerhalb des Tragkörpers 1 angeordnet sind. Im dargestellten Ausführungsbeispiel liegen auch die Einlaufdüsen 21 der Radialventilatoren 12 außerhalb des Tragkörpers 1. In diesem Falle ragen die Radialventilatoren 12 nur so weit durch die Aufnahmeöffnungen 8 bis 11, dass sie an der Innenseite der Seitenwände 2 bis 5 befestigt werden können.

Diese Anordnung der Radialventilatoren 12 hat zur Folge, dass die Kühlluft durch die Öffnung 7 angesaugt wird. Diese angesaugte Kühlluft durchströmt somit das im Bereich der Seitenwand 7 angeordnete zu kühlende Aggregat in umgekehrter Richtung wie bei der zuvor beschriebenen nicht erfindungsgemäßen Gebläseeinheit. Die Kühlluft gelangt in den Tragkörper 1 und wird dann über die Radialventilatoren 12 radial wieder nach außen geblasen. Die Gebläseeinheit nach den Fig. 5 bis 8 arbeitet somit saugend, während die Gebläseeinheit gemäß den Fig. 1 bis 4 drückend arbeitet.

Da die Gebläseeinheit nach den Fig. 5 bis 8 bis auf die unterschiedliche Anordnung der Radialventilatoren 12 gleich ausgebildet ist wie die zuvor beschriebene nicht erfindungsgemäße Gebläseeinheit, wird bezüglich der Ausbildung der erfindungsgemäßen Gebläseeinheit auf die Ausführungen zur nicht erfindungsgemäßen Gebläseeinheit verwiesen.

Das zu kühlende Aggregat, beispielsweise ein Wärmetauscher, kann sich über die gesamte Fläche der Seitenwand 7 erstrecken. In diesem Falle ist die Seitenwand 7 des Tragkörpers 1 vollständig offen. Die Seitenwand 7 kann aber auch nur wenigstens eine Öffnung aufweisen, durch welche die Kühlluft strömt. In diesem Falle ist der zu kühlende Bereich des zu kühlenden Aggregates flächenmäßig kleiner als die Seitenwand 7. Es besteht darüber hinaus die Möglichkeit, an der Seitenwand 7 zwei oder auch mehr zu kühlende kleinere Aggregate vorzusehen, für die jeweils eine Einströmöffnung in der Seitenwand 7 vorgesehen ist. Es ist aber auch möglich, in der vollständig offenen Seitenwand 7 mehrere solcher zu kühlender Aggregate nebeneinander vorzusehen.

Bei der Gebläseeinheit nach den Fig. 5 bis 8 kann ein weiterer Radialventilator 12 auch an der Rückwand 6 des Tragkörpers 1 angebracht sein.

Bei der beschriebenen Ausführungsform ergibt sich eine sehr hohe Leistungsdichte bei kleinem Bauraum. Da zur Kühlung nicht nur ein, sondern wenigstens zwei Radialventilatoren 12 eingesetzt werden, ergeben sich hervorragende akustische Eigenschaften. Zudem ergibt sich ein hoher Wirkungsgrad der Gebläseeinheit. Durch den Einsatz der Radialventilatoren 12 wird das zu kühlende Aggregat direkt von Kühlluft beaufschlagt, so dass die Strömungsverluste klein gehalten werden können. Auch sind dadurch keine zusätzlichen Umlenkungen innerhalb des Tragkörpers 1 für die Kühlluft notwendig. Da die Radialventilatoren 12 im Beispielsfall jeweils winklig zueinander angeordnet sind, erfolgt die Schallabstrahlung beim Einsatz der Gebläseeinheit in den entsprechenden Richtungen. Dies trägt zur hervorragenden geringen Geräuschentwicklung der Gebläseeinheit im Einsatz bei. Die Radialventilatoren 12 müssen auch nicht baulich voneinander getrennt werden, so dass auf den Einsatz beispielsweise von Trennblechen und dergleichen verzichtet werden kann. Durch die beschriebene Ausbildung ergibt sich ein nur geringer Versperrungseinfluss der Einbauverhältnisse auf die Kennlinie der Radialventilatoren.

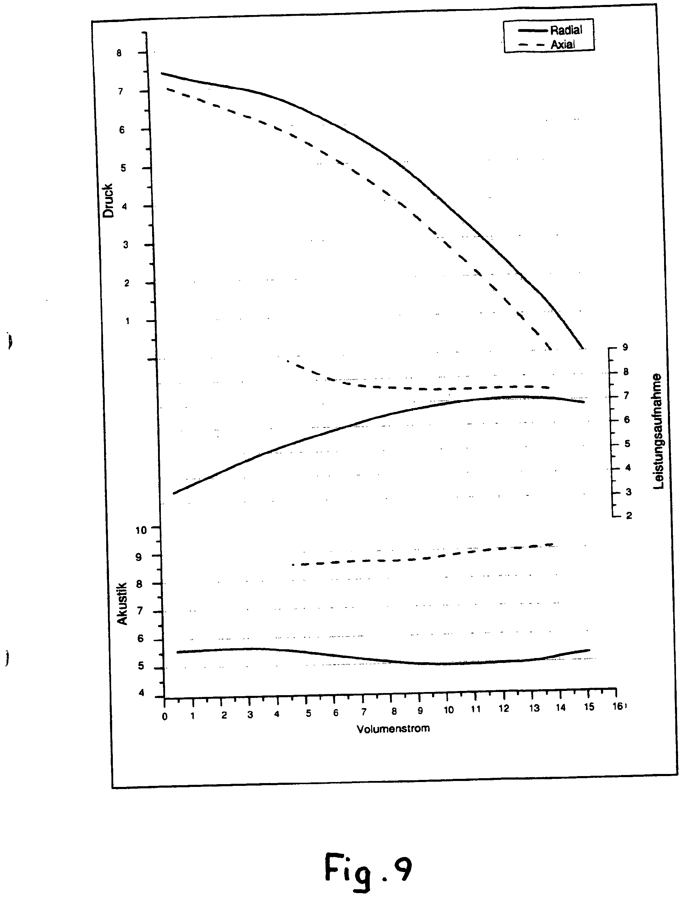

Fig. 9 zeigt verschiedene Kennlinien der dargestellten Gebläseeinheit, die mit einem Wärmetauscher als zu kühlendem Element verbunden ist. Im unteren Teil ist der Schalldruck L (Akustik) in Abhängigkeit vom Volumenstrom qᵥ der Radialventilatoren angegeben. Erkennbar ist, dass der Schalldruck über den gemessenen Volumenstrombereich bei der Gebläseeinheit mit den Radialventilatoren 12 wesentlich geringer ist als der Schallpegel L eines Axialventilators, der bisher für diesen Zweck eingesetzt worden ist.

Auch die Leistungsaufnahme der Gebläseeinheit mit den Radialventilatoren 12 ist über den gesamten gemessenen Volumenstrombereich geringer als bei Einsatz des üblichen Axialventilators.

Weiter zeigt die Druck-Volumen-Kennlinie, dass die Kennlinie für die Gebläseeinheit mit den Radialventilatoren 12 über den gemessenen Volumenstrombereich höher liegt als die Kennlinie für die Gebläseeinheit mit dem üblichen Axialventilator.

## Patentansprüche

1. Gebläseeinheit zur Kühlung von Aggregaten, wie elektrische/elektronische Baugruppen, Geräte und dergleichen,
mit wenigstens einem als Gehäuse mit Seitenwänden (2 bis 7) ausgebildeten Tragkörper (1), an dessen Seitenwänden (2 bis 7) wenigstens zwei Radialventilatoren (12) mit Lüfterräder (20) angeordnet sind, die an einander gegenüberliegenden und/oder winklig zueinander liegenden Seitenwänden (2 bis 5) des Tragkörpers (1) angeordnet sind, einen Luftstrom zur Kühlung des Aggregates erzeugen und deren Achsen (15) unter einem Winkel zur Achse (19) wenigstens einer Durchströmöffnung des Tragkörpers (1) liegen, die einen Innenraum (23) des Tragkörpers (1) mit einem Umgebungsraum strömungstechnisch verbindet, wobei die wenigstens eine Durchströmöffnung für den Luftstrom einer die Seitenwände (2 bis 5) verbindenden Rückwand (6) des Tragkörpers (1) gegenüberliegt, d.h. dass die wenigstens eine Durchströmöffnung an der Seitenwand (7) des Tragkörpers (1) vorgesehen ist,
**dadurch gekennzeichnet, dass** die Lüfterräder (20) der Radialventilatoren (12) außerhalb des Tragkörpers (1) liegen und die Kühlluft durch die wenigstens eine Durchströmöffnung angesaugt wird, das im Bereich der Seitenwand (7) angeordnete zu kühlende Aggregat durchströmt, in den Tragkörper (1) gelangt und dann über die Radialventilatoren (12) radial wieder nach außen geblasen wird.

2. Gebläseeinheit nach Anspruch 1,
**dadurch gekennzeichnet, dass** die Durchströmöffnung durch die offene Seitenwand (7) des Tragkörpers (1) gebildet ist.

3. Gebläseeinheit nach Anspruch 1,
**dadurch gekennzeichnet, dass** die Durchströmöffnung für den Luftstrom durch wenigstens eine Öffnung in der Seitenwand (7) des Tragkörpers (1) gebildet ist.

4. Gebläseeinheit nach einem der Ansprüche 1 bis 3, **dadurch gekennzeichnet**, die Drehachsen (15) zweier einander gegenüberliegender Radialventilatoren (12) in einer gemeinsamen Ebene liegen.

5. Gebläseeinheit nach einem der Ansprüche 1 bis 3, **dadurch gekennzeichnet, dass** die Drehachsen (15) zweier einander gegenüberliegender Radialventilatoren (12) in unterschiedlichen Ebenen liegen.

6. Gebläseeinheit nach einem der Ansprüche 1 bis 5, **dadurch gekennzeichnet, dass** die Radialventilatoren (12) in der zugehörigen Seitenwand (2 bis 5) mittig angeordnet sind.

7. Gebläseeinheit nach einem der Ansprüche 1 bis 5, **dadurch gekennzeichnet, dass** die Radialventilatoren (12) in der zugehörigen Seitenwand (2 bis 5) außermittig angeordnet sind.

## Claims

1. Fan unit for cooling of apparatus, such as electrical/electronic assemblies, equipment and the like, having at least one supporting body (1), which is designed as a housing with side walls (2 to 7), on the side walls (2 to 7) of which supporting body at least two radial fans (12) which have fan wheels (20) are arranged, which centrifugal fans are arranged on side walls (2 to 5) of the supporting body (1), which lie opposite one another and/or at an angle to one another, and generate an airflow for cooling the apparatus, and the axes (15) of which centrifugal fans lie at an angle to the axis (19) at least of one flow-through opening of the supporting body (1), which connects an interior (23) of the supporting body (1) to a surrounding space in terms of flow, the at least one flow-through opening for the airflow lying opposite a rear wall (6) of the supporting body (1), which connects the side walls (2 to 5), i.e. the at least one flow-through opening is provided on the side wall (7) of the supporting body (1),
**characterized in that** the fan wheels (20) of the radial fans (12) lie outside the supporting body (1) and the cooling air is sucked in through the at least one flow-through opening, flows through the apparatus to be cooled, which is arranged in the region of the side wall (7), reaches the supporting body (1) and is then blown radially to the outside again by means of the radial fans (12).

2. Fan unit according to Claim 1,
**characterized in that** the flow-through opening is formed by the open side wall (7) of the supporting body (1).

3. Fan unit according to Claim 1,
**characterized in that** the flow-through opening for the airflow is formed by at least one opening in the side wall (7) of the supporting body (1).

4. Fan unit according to one of Claims 1 to 3,
**characterized in that** the axes of rotation (15) of two mutually opposite radial fans (12) lie in a common plane.

5. The fan unit according to one of Claims 1 to 3,
**characterized in that** the axes of rotation (15) of two mutually opposite radial fans (12) lie in different planes.

6. Fan unit according to one of Claims 1 to 5,
**characterized in that** the radial fans (12) are arranged centrally in the associated side wall (2 to 5).

7. Fan unit according to one of Claims 1 to 5, **characterized in that** the radial fans (12) are arranged eccentrically in the associated side wall (2 to 5).

## Revendications

1. Unité de ventilateur pour le refroidissement de modules tels que des modules électriques/électroniques, appareils et similaires, comportant au moins un corps de support (1) réalisé sous la forme d'un boîtier avec des parois latérales (2 à 7), sur les parois latérales duquel (2 à 7) au moins deux ventilateurs radiaux (12) avec des hélices de ventilateur (20) sont disposées, qui sont disposées sur des parois latérales (2 à 5) mutuellement opposées et/ou inclinées l'une par rapport à l'autre du corps de support (1), génèrent un flux d'air pour refroidir l'unité et leurs axes (15) à un angle par rapport à l'axe (19) d'au moins une ouverture d'écoulement du corps de support (1), qui relie fluidiquement un intérieur (23) du corps de support (1) à un espace environnant, dans lequel la au moins une ouverture d'écoulement pour le flux d'air est opposée à une paroi arrière (6) du corps de support (1) reliant les parois latérales (2 à 5), c'est-à-dire que la au moins une ouverture d'écoulement est prévue sur la paroi latérale (7) du corps de support (1),
**caractérisée en ce que** les hélices de ventilateur (20) des ventilateurs radiaux (12) se situent à l'extérieur du corps de support (1) et l'air de refroidissement est aspiré à travers au moins une ouverture d'écoulement, s'écoule à travers le module à refroidir disposé dans la zone de la paroi latérale (7), atteint le corps de support (1) et est ensuite à nouveau soufflé radialement vers l'extérieur via les ventilateurs radiaux (12).

2. Unité de ventilateur selon la revendication 1,
**caractérisée en ce que** l'ouverture d'écoulement est formée par la paroi latérale ouverte (7) du corps de support (1).

3. Unité de ventilateur selon la revendication 1,
**caractérisée en ce que** l'orifice d'écoulement pour le flux d'air est formé par au moins une ouverture dans la paroi latérale (7) du corps de support (1).

4. Unité de ventilateur selon une des revendications 1 à 3, **caractérisée en ce que** les axes de rotation (15) de deux ventilateurs radiaux opposés (12) se situent dans un plan commun.

5. Unité de ventilateur selon une quelconque des revendications 1 à 3, **caractérisée en ce que** les axes de rotation (15) de deux ventilateurs radiaux opposés (12) se trouvent dans des plans différents.

6. Unité de ventilateur selon une quelconque des revendications 1 à 5, **caractérisée en ce que** les ventilateurs radiaux (12) sont disposés au centre de la paroi latérale associée (2 à 5).

7. Unité de ventilateur selon une quelconque des revendications 1 à 5, **caractérisée en ce que** les ventilateurs radiaux (12) sont disposés de manière excentrée dans la paroi latérale associée (2 à 5)
